## Europäisches Patentamt
## European Patent Office
## Office européen des brevets

(11) Veröffentlichungsnummer: **0 365 994**

**A2**

(12) # EUROPÄISCHE PATENTANMELDUNG

(21) Anmeldenummer: **89119335.1**

(22) Anmeldetag: **18.10.89**

(51) Int. Cl.5: **H01S 3/139 , H01S 3/105 , H01S 3/085**

(30) Priorität: **22.10.88 DE 3836116**

(43) Veröffentlichungstag der Anmeldung:
**02.05.90 Patentblatt 90/18**

(84) Benannte Vertragsstaaten:
**AT BE CH DE ES FR GB IT LI NL SE**

(71) Anmelder: **Standard Elektrik Lorenz Aktiengesellschaft**
**Lorenzstrasse 10**
**D-7000 Stuttgart 40(DE)**

(84) **DE**

Anmelder: **ALCATEL N.V.**
**Strawinskylaan 341 (World Trade Center)**
**NL-1077 XX Amsterdam(NL)**

(84) **BE CH ES FR GB IT LI NL SE AT**

(72) Erfinder: **Strobel, Otto A., Prof. Dr.**
**Rinnenbachstrasse 31**
**D-7302 Ostfildern 2(DE)**

(74) Vertreter: **Gähr, Hans-Dieter, Dipl.-Ing. (FH) et al**
**Standard Elektrik Lorenz AG Patent- und Lizenzwesen Postfach 30 09 29**
**D-7000 Stuttgart 30(DE)**

(54) **Geregelter Halbleiterlaser.**

(57) FP-Halbleiterlaser schwingen im unbeeinflußten Zustand in der Regel mehrmodig. Bei kohärenter Übertragung oder in der hochkohärenten Sensortechnik wird vom Laser (1) Monomodigkeit verlangt. Dieses wird bei derartigen Halbleiterlasern durch Unterdrücken der Nebenmoden (15) mittels eines äußeren Resonators (11) erreicht, der über einen Regelkreis eingestellt wird.

Die Erfindung sieht einen Regelkreis vor, bei dem aus der Höhe des relativen Intensitätsrauschens als Meßgröße auf den Modenzustand der Laserstrahlung geschlossen wird. Über eine abgeleitete Stellgröße wird der äußere Resonator (11) jeweils so eingestellt, daß der Laser (1) monomodig schwingt.

FIG.1

## Geregelter Halbleiterlaser

Die Erfindung geht von einem geregelten Halbleiterlaser gemäß dem Oberbegriff des Anspruchs 1 aus.

Halbleiterlaser vom Fabry-Perot(FP)-Typ schwingen im unbeeinflußten Zustand in der Regel mehrmodig. Bei kohärenter Übertragung wird vom Laser Monomodigkeit verlangt. Diese läßt sich bei Halbleiterlasern der vorgenannten Art durch Unterdrücken der Nebenmoden erreichen. Dieser Zustand ist von mehreren Variablen abhängig und daher nicht stabil. Er läßt sich jedoch über einen Regelkreis einstellen.

Ein derart geregelter Halbleiterlaser ist durch die EP-A-0 108 562 bekannt. In Ausrichtung auf das Rücklicht des Lasers ist hinter dem Laser eine Fotodiode angeordnet. Zwischen dem Laser und der Fotodiode ist als äußerer Resonator ein Reflektor angeordnet. Der Reflektor hat Löcher, durch die ein Teil des Rücklichtes auf die Fotodiode fällt, während der übrige Teil der Strahlung durch den Reflektor in den Laser rückgekoppelt wird. Bei einem bestimmten Abstand des Reflektors zum Laser werden bis auf den Hauptmodus die benachbarten Nebenmoden unterdrückt.

Der Abstand des Reflektors zum Laser ist durch einen Elektromagneten als Stellglied in Grenzen veränderbar. Die Fotodiode und der Elektromagnet sind Eingangs- bzw. Ausgangselement eines Regelkreises. Es ist ein phasenabhängiger Detektor vorhanden, der aus dem Fotodiodenstrom und einem Oszillatorsignal ein polarisiertes Ausgangssignal bildet, das proportional der momentanen Lichtleistung des Lasers ist. Aus dem Vergleich dieses Signals mit einer Bezugsgröße wird eine Stellgröße abgeleitet, die den Reflektor auf die maximale Lichtleistung des Lasers einstellt.

Die Aufgabe der Erfindung besteht darin, eine andere Ausführung eines geregelten Halbleiterlasers zu schaffen.

Die durch die Erfindung erzielten Vorteile bestehen insbesondere darin, daß das Maß des relativen Intensitätsrauschens das Kriterium für den Modenzustand der Laserstrahlung ist.

Anhand eines Ausführungsbeispiels wird die Erfindung in Verbindung mit den Zeichnungen nachfolgend näher beschrieben. Es zeigen:

Fig. 1 das Blockschaltbild einer Regelschaltung zum Betrieb eines Multimode-Halbleiterlasers zum Erzielen des Monomode-Betriebs; und

Fig. 2 das relative Intensitätsrauschen eines Halbleiterlasers in Abhängigkeit von der Frequenz bei Multimode- und Monomodebetrieb.

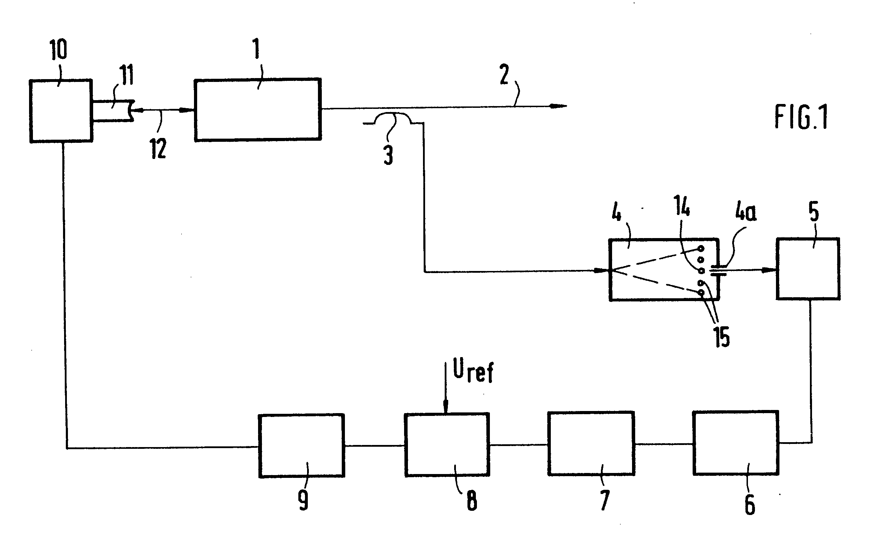

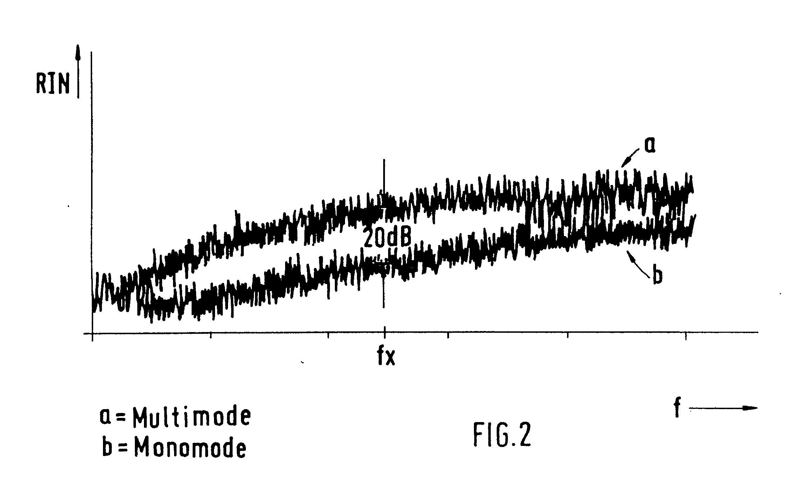

Fig. 1 zeigt das Blockschaltbild einer Regelschaltung zum Betrieb eines Mulitmode-Lasers zum Erzielen des Monomode-Betriebs. An einen üblicherweise temperaturgeregelten Halbleiterlaser 1 ist ein Lichtwellenleiter 2 zu Übertragungszwekken angekoppelt. Über einen Faserkoppler 3 erfolgt eine Teilauskopplung der Laserstrahlung. Diese wird einem an sich bekannten Bewegungsgitter 4 zugeführt, durch das die Moden aufgrund unterschiedlicher Wellenlänge räumlich nebeneinander angeordnet werden. Aus den hier bildhaft als unterschiedlich große Punkte dargestellten Moden 14, 15 wird über einen Spalt 4a der Wellenlängenbereich des Modus mit der größten Amplitude als Hauptmodus 14 ausgeblendet. Auf den Spalt 4a ist die Fotodiode eines Fotodetektors 5 ausgerichtet, dessen Ausgang mit einem Bandfilter 6 verbunden ist. Dieses Filter hat einen schmalen Durchlaßbereich von z.B. 300 Hz. Dieser ist innerhalb des Frequenzspektrums des Ausgangssignals des Detektors 5 dort angeordnet (Fig. 2, $f_x$), wo die Rauschpegeldifferenz zwischen Multimode- und Monomodebetrieb des Lasers 1 am höchsten ist. Dem Bandfilter 6 ist eine Gleichrichteranordnung 7 nachgeordnet, die mit einer Vergleichsanordnung 8 verbunden ist. An dieser ist ein Rampengenerator 9 angeschlossen, der die Steuerspannung für ein Piezoelement 10 liefert. Das Piezoelement 10 bildet eine Einheit mit einem äußeren Resonator 11. Dieser ist z.B. ein in Längsrichtung auf die Rückstrahlung 12 des Lasers 1 ausgerichtetes Materialstück, dessen zum Laser 1 gerichtete Stirnfläche als konkaver Spiegel ausgebildet ist. Der Abstand dieser Spiegelfläche zum Laser 1 ist so gewählt, daß letzterer ·durch Überlagerung der originären Strahlung mit der reflektierten Strahlung in gewünschter Weise nur einmodig schwingt, d.h., die Nebenmoden 15 werden unterdrückt, wie in der eingangs genannten Schrift näher erläutert ist. Abweichungen von diesem Zustand werden durch die vorbeschriebene Regelschaltung erkannt und durch Nachführen des äußeren Resonators 11 über das Piezoelement 10 als Stellglied ausgeglichen.

Die Funktionsweise der Regelschaltung gemäß Fig. 1 wird nachfolgend in Verbindung mit der Fig. 2 näher erläutert. Der über den Faserkoppler 3 ausgekoppelte Strahlungsanteil sollte einerseits so klein wie möglich sein, um Nutzlichtanteilverluste klein zu halten, muß andererseits jedoch groß genug sein, um einen stabilen Regelbetrieb zu gewährleisten.

Durch das Beugungsgitter 4 und den Spalt 4a wird, wie bereits beschrieben, der Hauptmodus 14 ausgeblendet. Damit trifft auf die Fotodiode des Detektors 5 nur der durch die Breite des Spaltes 4a bestimmte Wellenlängenbereich des Hauptmodus 14. Im Fotodetektor 5 wird die empfangene Lichtleistung in einen Gleichstrom proportionaler Größe umgewandelt, der entsprechend dem Rauschenergieanteil der Strahlung moduliert ist. Der Rauschpegel ist am geringsten im Monomode-Zustand des Lasers 1 und nimmt im Multimode-Zustand wegen der schwankenden Energieverteilung zwischen den Moden zu.

Fig. 2 zeigt in Gegenüberstellung das relative Intensitätsrauschen RIN im Ausgangssignal des Detektors 5 bei Multimode-Betrieb (a) und bei Monomode-Betrieb (b) des Lasers 1 über der Frequenz f. An einer Stelle im betrachteten Signalbereich erreicht die Differenz der Rauschintensität bei Multimode- und Monomode-Betrieb ein Maximum. Diese liegt beim vorliegenden Beispiel mit 20 dB Abstand bei der Frequenz $f_x$. An diese Stelle ist das nachgeordnete Bandfilter 6 mit der Durchlaßbreite von beispielsweise 300 Hz gelegt, dessen Ausgangssignal durch die Gleichrichteranordnung 7 gleichgerichtet wird. Die sich ergebende Gleichspannung ist die Meßgröße, die ein direktes Maß für die Größe des relativen Intensitätsrauschens RIN ist, über das auf das Modenverhalten des Lasers 1 rückgeschlossen werden kann. In der an sich bekannten Vergleichsanordnung 8 wird die Ausgangsspannung der Gleichrichteranordnung 7 mit einer Bezugsspannung $U_{ref}$ als Schwelle verglichen. Diese liegt über dem Gleichspannungswert, der die Gleichrichteranordnung 7 abgibt, wenn der Laser 1 monomodig schwingt. Wird der Monomode-Betrieb z.B. durch äußere Einflüsse gestört, so daß die bisher unterdrückten Nebenmoden anschwingen, steigt auch der Rauschpegel und damit die Ausgangsspannung der Gleichrichteranordnung 7. Überschreitet diese die Bezugsschwelle der Vergleichsanordnung 8, so wird über diese der Rampengenerator 9 in Betrieb genommen. Es handelt sich bei diesem z.B. um einen an sich bekannten Funktionsgenerator, der eine dreieckförmige Spannung erzeugt, die über das Piezoelement 10 bewirkt, daß sich der Abstand des äußeren Resonators 11 zum Laser verändert. Über den Regelkreis wird im Verlauf einer steigenden oder fallenden Flanke der Dreiecksspannung des Rampengenerators 9 mit dem Unterschreiten der Bezugsschwelle über die Vergleichsanordnung 8 die Stellung des äußeren Resonators 11 durch Anhalten des Rampengenerators 9 so fixiert, daß durch optimale Rückkopplung der Rückstrahlung 12 alle Nebenmoden 15 wieder unterdrückt sind.

Die vorbeschriebene Regelung kann auch in der hochkohärenten Sensortechnik verwendet werden, bei der ebenfalls die Forderung nach der Monomodigkeit des verwendeten Lasers besteht.

## Ansprüche

1. Geregelter Halbleiterlaser für Monomode-Betrieb, bei dem ein Teil der Laserstrahlung mittels eines äußeren Resonators in den Laser rückgekoppelt wird, wobei der Abstand des äußeren Resonators zum Laser über ein Stellglied durch eine Stellgröße einstellbar ist und die Stellgröße aus dem Vergleich einer Bezugsgröße mit einem aus der Laserstrahlung abgeleiteten Meßgröße gebildet wird, **dadurch gekennzeichnet,** daß die Meßgröße aus dem relativen Intensitätsrauschen der Strahlung des Lasers (1) abgeleitet wird.

2. Halbleiterlaser nach Anspruch 1, dadurch gekennzeichnet, daß zum Ermitteln der Meßgröße ein Teil der Laserstrahlung einem Bewegungsgitter (4) zugeführt und räumlich in seine Moden (14, 15) zerlegt wird, daß der Hauptmodus (14) auf einen Fotodetektor (5) projiziert wird, daß das Ausgangssignal des Detektors (5) einem schmalbandigen Bandfilter (6) zugeführt wird, das aus dem Frequenzspektrum des Ausgangssignals des Detektors (5) einen dem Durchlaßbereich des Bandfilters (6) entsprechenden Bereich selektiert, daß das Ausgangssignal des Bandfilters (6) durch eine Gleichrichteranordnung (7) gleichgerichtet wird und daß der sich dabei ergebende Gleichspannungswert die Meßgröße ist.

3. Halbleiterlaser nach Anspruch 2, dadurch gekennzeichnet, daß der Durchlaßbereich des Bandfilters (6) innerhalb des Frequenzspektrums des Ausgangssignals des Detektors (5) dort liegt, wo die Rauschpegeldifferenz zwischen dem Multimode- und Monomodebetrieb des Lasers (1) hoch ist.

FIG.1

a = Multimode
b = Monomode

FIG.2

EP 0 365 994 A2

O. A. Strobel 4
11. 11. 88